# EUROPEAN PATENT APPLICATION

(11) **EP 4 654 767 A1**
(43) Date of publication of application: **26.11.2025**
(21) Application number: 24214661.1
(22) Date of filing: 21.11.2024
(51) Int. Cl.: H05K 7/20

(54) **ENERGY STORAGE CONVERTER**

(30) Priority: 21.05.2024 CN 202410638573; 21.05.2024 CN 202410646195
(71) Applicant: Zhejiang Jinko Energy Storage Co., Ltd., Jiaxing, Zhejiang (CN)
(72) Inventor: ZHANG, Luhua, Haining (CN); YU, Jian, Haining (CN)
(74) Representative: Balder IP Law, S.L.

(57) **Abstract**

Provided is an energy storage converter, including: a shell (201) and a baseplate forming a chamber (200); inductors (220) and IGBT modules (210) disposed within the chamber (200); and a liquid-cooled assembly on the baseplate. The liquid-cooled assembly includes a liquid-cooled plate (100) internally provided with a flow-splitting structure (110) including a coolant inlet (101), N flow-splitting channels (111), a component cooling channel (112) and a coolant outlet (101). The flow-splitting channels and the component cooling channel are in fluid communication with the coolant inlet. The flow-splitting channels are connected in parallel to each other. The component cooling channel is connected in parallel to the flow-splitting channels or connected in series to at least one of the flow-splitting channels, and each flow-splitting channel includes a first sub-flow channel (121) and a second sub-flow channel (122) connected in series.

## Description

### TECHNICAL FIELD

Embodiments of the present disclosure relate to the field of energy storage, and in particular, to an energy storage converter.

### BACKGROUND

With the rapid development of power electronics technology, the power consumption leads to the increase in heat flow density. The main factors affecting the working environment in which electronic equipment is located include: temperature, sand, dust, precipitation, etc. In order to ensure that the power electronic equipment can reliably and fully operate in various types of environments, it is necessary to make adaptive design for the environments. Power devices are the main source of heat generation, and are the key devices in most electronic equipment, and the working conditions of the power devices directly affect the reliability of the whole machine. Therefore, the heat dissipation of high-power devices is the key to the heat dissipation of the whole electronic equipment. Forced air cooling and liquid cooling are widely used in the cooling system of electronic equipment that needs to dissipate heat, and are also the main cooling form adopted by the high-power devices.

In the application of high-power converters, due to the complexity of the main circuit, there are more heat sources, including generator-side IGBT modules, grid-side IGBT modules and capacitor arrays, and it is difficult to ensure uniform and efficient heat dissipation of the IGBT modules, resulting in no current sharing of the modules, which affects the service life of the modules, and even leads to the blowing up of the modules.

Therefore, how to prepare a heat sink structure which is capable of improving the heat dissipation effect inside the converter and has simple and compact structure is a problem that needs to be resolved urgently.

### SUMMARY

Embodiments of the present disclosure provide an energy storage converter, which at least facilitates improving the heat dissipation effect of the converter.

According to some embodiments of the present disclosure, an aspect of the embodiments of the present disclosure provides an energy storage converter. The energy storage converter includes: a shell and a baseplate; inductors and insulated-gate bipolar transistor (IGBT) modules; and a liquid-cooled assembly. The shell and the baseplate form a chamber. The inductors and the IGBT modules are disposed within the chamber. The liquid-cooled assembly is located on the baseplate, and includes a liquid-cooled plate internally provided with a flow-splitting structure. The flow-splitting structure includes a coolant inlet, N flow-splitting channels and a component cooling channel. The N flow-splitting channels and the component cooling channel are in fluid communication with the coolant inlet. The N flow-splitting channels are connected in parallel to each other. The component cooling channel is connected in parallel to the N flow-splitting channels, or connected in series to at least one of the N flow-splitting channels. Each of the N flow-splitting channels includes a first sub-flow channel and a second sub-flow channel connected in series, where N≥2. The N flow-splitting channels corresponds to the IGBT modules, and the component cooling channel corresponds to the inductors.

In some embodiments, the flow-splitting structure further includes a coolant outlet, and in response to the component cooling channel being connected in series to at least one of the N flow-splitting channels, inlets of the N flow-splitting channels are in fluid communication with the coolant inlet, an outlet of the at least one of the N flow-splitting channels is in fluid communication with an inlet of the component cooling channel, and an outlet of the component cooling channel is in fluid communication with the coolant outlet.

In some embodiments, the flow-splitting structure further includes a coolant outlet, and in response to the component cooling channel being connected in parallel to the N flow-splitting channels, an inlet of the component cooling channel is in fluid communication with the coolant inlet, an outlet of the component cooling channel is in fluid communication with the coolant outlet, inlets of the N flow-splitting channels are in fluid communication with the coolant inlet, and outlets of the N flow-splitting channels are in fluid communication with the coolant outlet.

In some embodiments, at least one of the first sub-flow channel and the second sub-flow channel includes a first trunk section, a first connecting section, a cooling region, a second connecting section and a second trunk section sequentially connected to each other, where a cross-sectional area of the first connecting section is greater than or equal to a cross-sectional area of the first trunk section.

In some embodiments, a ratio of a first width of the first trunk section to a second width of the first connecting section is 0.15 to 1.

In some embodiments, the first width ranges from 12.5 mm to 30 mm.

In some embodiments, the second width ranges from 12.5 mm to 81 mm.

In some embodiments, a length of the first connecting section ranges from 0 mm to 69 mm.

In some embodiments, a length of the cooling region ranges from 56 mm to 152 mm, and a third width of the cooling region ranges from 81 mm to 92 mm.

In some embodiments, at least one of the first sub-flow channel and the second sub-flow channel includes a first trunk section, a cooling region, a second trunk section, and a bending section sequentially connected to each other, the bending section having a number of times of bending greater than or equal to 2.

In some embodiments, at least one of the first sub-flow channel and the second sub-flow channel includes a first trunk section, a cooling region, a bending section, and a second trunk section sequentially connected to each other, the bending section having a number of times of bending greater than or equal to 2.

In some embodiments, the cooling region has a buffer structure, and an included angle between the buffer structure and a first direction is less than 90°, where the first direction is perpendicular to a flow direction of a coolant in the cooling region.

In some embodiments, the cooling region includes a plurality of first flow channels alternatingly bent.

In some embodiments, a flow disruption column is provided in the cooling region.

In some embodiments, the flow disruption column includes a spring-loaded flow disruption ring, a water drop-shaped flow disruption column, a flow disruption ring.

In some embodiments, the cooling region has a first inlet and a first outlet disposed opposite to each other along a second direction or staggered along a second direction, the second direction being a flow direction of a coolant.

In some embodiments, at least one of the first sub-flow channel or the second sub-flow channel includes a plurality of end flow-splitting channels in parallel.

In some embodiments, the component cooling channel includes a plurality of third sub-flow channels connected in parallel.

### BRIEF DESCRIPTION OF THE DRAWINGS

One or more embodiments are exemplarily described with reference to the corresponding figures in the accompanying drawings, and the descriptions are not to be construed as limiting the embodiments. Unless otherwise particularly stated, the figures in the accompanying drawings are not drawn to scale. To describe technical solutions of embodiments of the present disclosure more clearly, the following briefly introduces the accompanying drawings required for the embodiments. Apparently, the accompanying drawings in the show only some embodiments of the present disclosure, and a person of ordinary skill in the art may still derive other drawings from these accompanying drawings without creative efforts.
FIG. 1 is a schematic view showing a structure of an energy storage converter according to an embodiment of the present disclosure.
FIG. 2 is a top view showing a structure of the energy storage converter according to an embodiment of the present disclosure.
FIG. 3 is a schematic view showing a structure of a liquid-cooled assembly in the energy storage converter according to an embodiment of the present disclosure.
FIG. 4 is a schematic view showing another structure of the liquid-cooled assembly in the energy storage converter according to an embodiment of the present disclosure.
FIG. 5 is a schematic view showing a structure of a first sub-flow channel of the liquid-cooled assembly in the energy storage converter according to an embodiment of the present disclosure.
FIG. 6 is a schematic view showing another structure of the first sub-flow channel of the liquid-cooled assembly in the energy storage converter according to an embodiment of the present disclosure.
FIG. 7 is a schematic view showing yet another structure of the first sub-flow channel of the liquid-cooled assembly in the energy storage converter according to an embodiment of the present disclosure.
FIG. 8 is a schematic view showing still yet another structure of the first sub-flow channel of the liquid-cooled assembly in the energy storage converter according to an embodiment of the present disclosure.
FIG. 9 is another top view of an energy storage converter according to an embodiment of the present disclosure.
FIG. 10 is yet another top view of the energy storage converter according to an embodiment of the present disclosure.
FIG. 11 is a schematic view showing a structure of a liquid-cooled assembly in the energy storage converter according to an embodiment of the present disclosure.
FIG. 12 is a schematic view showing a structure of a flow-splitting structure the liquid-cooled assembly in the energy storage converter according to an embodiment of the present disclosure.
FIG. 13 is a schematic view showing another structure of the liquid-cooled assembly in the energy storage converter according to an embodiment of the present disclosure.
FIG. 14 is a schematic view showing a structure of a first sub-flow channel in the liquid-cooled assembly in the energy storage converter according to an embodiment of the present disclosure.
FIG. 15 is a schematic view showing another structure of a first sub-flow channel in the liquid-cooled assembly in the energy storage converter according to an embodiment of the present disclosure.

### DETAILED DESCRIPTION OF THE EMBODIMENTS

As can be seen from background, existing energy storage converters have a relatively poor heat dissipation effect.

After analysis, it is found that one of the reasons leading to the relatively poor heat dissipation effect on the existing energy storage converters is that: if cooling plates have non-uniform flow distribution, a temperature on a certain cell would be too high; and it is difficult to ensure the uniformity of the flow distribution in different flow channels in a certain cooling plate, which may result in a too high temperature at a certain position on the cooling plate. Generally, if the flow distribution on the cooling plate is uniform, a maximum temperature difference on the cooling plate is generally less than 5 °C, or even less than 3 °C. If the flow distribution difference is relatively large, the temperature difference on the cooling plate may be up to more than 10 °C, which cannot meet the thermal management requirements of the power battery.

Embodiments of the present disclosure provide an energy storage converter. The liquid-cooled assembly is provided to include N flow-splitting channels connected in parallel, thereby ensuring uniform and efficient heat dissipation of IGBT modules, so that the heat dissipation effect on the converter is effectively improved. Secondly, N flow-splitting channels are provided to be connected in parallel, which ensures similar cooling effects on the IGBT modules, i.e., satisfying the requirement of uniformity in the cooling effects on the IGBT modules, and facilitating ensuring the service life of the power modules. Thirdly, the N flow-splitting channels and the component cooling channel are configured to cool down, with a cooling channel therebetween, two kinks of components in a limited space, so that the spatial tightness of the liquid-cooled plate can be improved, thereby improving the integration degree inside the converter.

In the description of the embodiments of the present disclosure, the technical terms "first," "second," etc. are only used to distinguish different objects, and are not to be understood as indicating or implying relative importance or implicitly specifying the number, the specific order or the primary and secondary relation of the technical features indicated. In the description of the embodiments of the present disclosure, "plurality" refers to two or more, unless otherwise expressly and specifically limited.

"Embodiment" herein means that particular features, structures, or characteristics described in conjunction with embodiments may be included in at least one embodiment of the present disclosure. The phrase present at various positions in the specification does not necessarily refer to the same embodiment, nor is it a separate or alternative embodiment that is mutually exclusive of other embodiments. It is understood by those skilled in the art, both explicitly and implicitly, that the embodiments described herein may be combined with other embodiments.

In the description of embodiments of the present disclosure, the term "and/or" is merely a description of an association relationship of associated objects, indicating that three kinds of relationships may exist. For example, A and/or B may indicate three cases: the existence of A, the existence of both A and B, and the existence of B. In addition, the character "/" herein generally indicates that the associated objects are in an "or" relationship.

In the description of embodiments of the present disclosure, the term "plurality" refers to two or more.

In the description of embodiments of the present disclosure, orientational or positional relationships indicated by technical terms "center," "longitudinal," "transverse," "length," "depth," "thickness," "above," "below," "front," "back," "left," "right," "vertical," "horizontal," "top," "bottom," "inside," "outside," "clockwise," "anticlockwise," "axial," "radial," "circumferential" and the like are based on orientational or positional relationships illustrated in the drawings, which are merely intended to facilitate and simplify the description of the present disclosure. These orientational or positional relationships do not indicate or imply that an apparatus or component referred to have a specific orientation and is constructed and operated in a specific orientation, and thus are not to be construed as limiting the present disclosure.

In the description of embodiments of the present disclosure, unless otherwise expressly and specifically limited, technical terms "mount," "connect," "inter-connect," "fix" should be understood in a broad sense. For example, these technical terms may refer to fixed connection, removable connection, or monolithic construction; may also refer to mechanical connection or electrical connection; may also refer to direct connection, or indirect connection through an intermediate medium; and may also refer to internal communication between two devices, or interaction between two elements. To a person of ordinary skill in the art, the specific meanings of the above terms in the present disclosure may be understood according to the specific circumstances.

In the accompanying drawings corresponding to embodiments of the present disclosure, the thickness and area of the layer are enlarged for better understanding and ease of description. When a component (e.g., a layer, film, area, or substrate) is described as being on another component or on a surface of another component, the component may be "directly" located at the surface of the another component, or there may be a third component between the two components. Conversely, when a component is described as being at a surface of another component, or a surface of a component is described as being formed or provided with another component, there is no third component between the two components. Furthermore, when a component is described as being formed "substantially" on another component, it means that the component is not formed on the entire surface (or front surface) of the another component, and is also not formed on a partial edge of the entire surface.

In the description of embodiments of the present disclosure, when a component "includes" another component, this does not exclude other components unless otherwise stated, and other components may be further included. In addition, when a component such as a layer, film, area or plate is described to be "over/on" another component, the component may be "directly on" the another component (i.e., located on the surface of the another component without other components therebetween), or there may be another component therebetween. In addition, when a component such as a layer, film, area or plate is "directly on" another component, or when a component such as a layer, film, area or plate is located on the surface of another component, it means that there is no other component therebetween.

The terms used herein in the description of various described embodiments are used only to describe particular embodiments and are not intended to be limiting. As used in the description of the various embodiments described and in the appended claims, "the part" is also intended to include the plural form, unless the context clearly indicates otherwise. "The part" includes a component such as a layer, film, area or plate.

Various embodiments of the present disclosure are described in detail below in connection with the accompanying drawings. However, a person of ordinary skill in the art may understand that in the various embodiments of the present disclosure, a number of technical details have been proposed to enable the reader to better understand the present disclosure. However, even without these technical details and various variations and modifications based on the following embodiments, the technical solutions claimed to be protected by the present disclosure can be achieved.

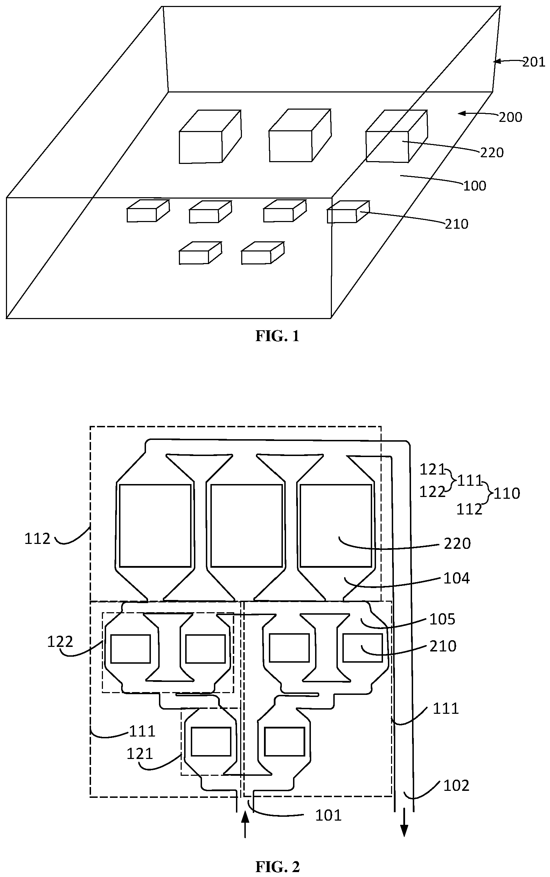

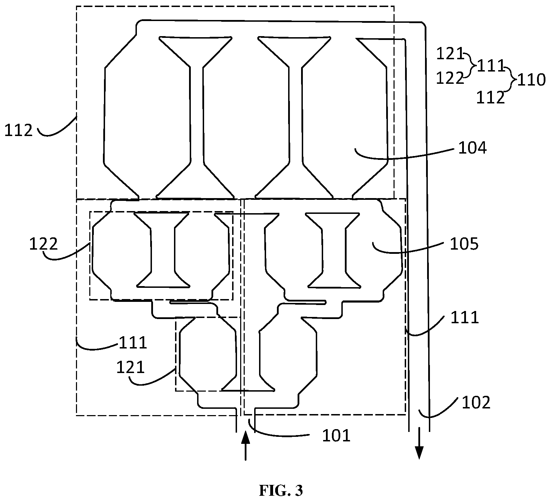

FIG. 1 is a schematic view showing a structure of an energy storage converter according to an embodiment of the present disclosure. FIG. 2 is a top view showing a structure of the energy storage converter according to an embodiment of the present disclosure. FIG. 3 is a schematic view showing a structure of a liquid-cooled assembly in the energy storage converter according to an embodiment of the present disclosure.

Referring to FIG. 1 and FIG. 2, according to some embodiments of the present disclosure, an energy storage converter is provided. The energy storage converter includes: a shell 201, a baseplate, an inductor 220, an insulated-gate bipolar transistor (IGBT) module 210, and a liquid-cooled assembly. The shell 201 and the baseplate form a chamber 200. The inductor 220 and the IGBT module 210 are disposed within the chamber 200. The liquid-cooled assembly is disposed on the baseplate.

In some embodiments, the energy storage converter serves as a flexible interface between an energy storage device and a power grid to achieve real-time communication with a battery management system, is developed using highly reliable intelligent power modules, and achieves bidirectional flow of energy between an alternating current (AC) system and a direct current (DC) system through the integrated design of charging and discharging.

Referring to FIG. 3, the liquid-cooled assembly includes: at least one liquid-cooled plate 100 (referring to FIG. 1).

In some embodiments, the liquid-cooled plate 100 may be a composite plate formed by at least two pieces of hot-press moulded metal plates, and a cooling channel is formed inside the composite plate by blowing and expanding of the composite plate with a high pressure gas, that is, between faying surfaces of two pieces of metal plates, a solder resist area printed with solder resist is blown and expanded with a high pressure gas, and the solder resist area is shaped to be a flow path for a cooling channel. Due to the solder resist, the solder resist regions of two neighbouring metal plates are not combined together under the heat pressure, so that the cooling channel can be formed by blowing and expanding of the regions of the metal plates with a high pressure gas.

Since the cooling channel is directly formed by blowing and expanding inside the composite plate, the cooling channel has a good sealing performance, and the formation of the cooling channel by blowing and expanding does not require a large thickness of the composite plate, and the cooling channel can be formed by blowing and expanding under the condition of satisfying the structural strength. Therefore, the thickness of the liquid-cooled plate is reduced. With reduced thickness, the liquid-cooled plate can be easier to bend and deform. For different shapes and sizes of electronic devices (such as IGBT modules and inductors), when the liquid-cooled plate is bent, the heat dissipation contact area between the liquid-cooled plate and the electronic components increases. For a plurality of electronic devices that are not coplanar, it is also possible to bend the composite plate so that the plurality of electronic devices are all in contact with the liquid-cooled plate to dissipate heat, which improves the heat dissipation effect and meets the heat dissipation needs of different electronic devices.

In some embodiments, the metal plate is preferably an aluminium plate, and the aluminium plate has the advantages of low melting point and good extensibility, and is easy in hot press molding and blowing and expanding. Of course, other metal plates with similar properties may be used, such as copper plates or alloy plates.

In some embodiments, the liquid-cooled plate and the baseplate are two independent devices, the liquid-cooled plate is located on the baseplate, and the inductors and the IGBT modules are located on the liquid-cooled plate.

In some embodiments, the liquid-cooled plate and the baseplate are the same device, and the liquid-cooled plate is not only used for cooling the devices such as inductors and IGBT modules, but also serves as a baseplate for support and load-bearing of the devices located in the chamber.

In order to facilitate the connection of external pipes to the cooling channel, the liquid-cooled plate in the embodiments of the present disclosure also includes a coolant inlet 101 and a water outlet 102 disposed at two ends of the cooling channel respectively. A direction of an arrow in the figures is a flow direction of liquid, and is also a second direction. A first direction is perpendicular to the second direction.

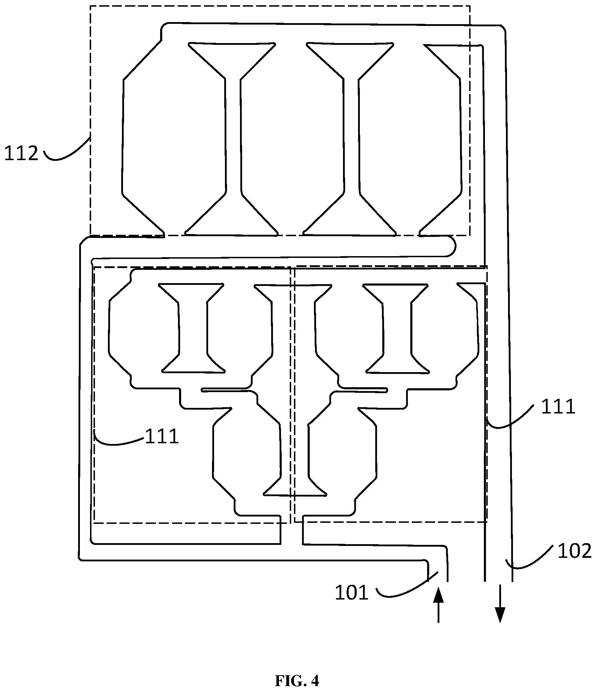

With continued reference to FIG. 3 or FIG. 4, the liquid-cooled assembly includes: a flow-splitting structure 110. The flow-splitting structure 110 has a coolant inlet 101, N flow-splitting channels 111, and a component cooling channel 112. The N flow-splitting channels 111 and the component cooling channel 112 are in fluid communication with the coolant inlet 101. The N flow-splitting channels 111 are connected in parallel to each other. The component cooling channel 112 is connected in parallel to the N flow-splitting channels 111, or is connected in series to at least one of the N flow-splitting channels 111. Each of the N flow-splitting channels 111 includes a first sub-flow channel 121 and a second sub-flow channel 122 connected in series, where N≥2.

In some embodiments, the liquid-cooled assembly is provided to include N flow-splitting channels 111 connected in parallel, thereby ensuring uniform and efficient heat dissipation of IGBT modules, so that the heat dissipation effect on the converter is effectively improved. Secondly, N flow-splitting channels 111 are provided to be connected in parallel, which ensures similar cooling effects on the IGBT modules, i.e., satisfying the requirement of uniformity in the cooling effects on the IGBT modules, and facilitating ensuring the service life of the power modules. Thirdly, the N flow-splitting channels 111 and the component cooling channel 112 are configured to cool down, with a cooling channel therebetween, two kinks of components in a limited space, so that the spatial tightness of the liquid-cooled plate can be improved, thereby improving the integration degree inside the converter.

Referring to FIG. 3, in some embodiments, the coolant inlet 101 is connected to N flow-splitting channels 111. The N flow-splitting channels 111 are connected in parallel to each other, and then merge into a main branch, which is then connected in series to the component cooling channel 112. The cooling channel first passes through the N flow-splitting channels 111, and then passes through the component cooling channel 112, which can satisfy the high temperature demand of the IGBT modules, thus ensuring the heat dissipation effect on the IGBT modules and enabling similar cooling effects on the IGBT modules. For the inductors corresponding to the component cooling channel 112, it is only necessary to ensure the presence of the heat dissipation effect, which can meet the requirements of the component cooling channel 112. Therefore, different requirements of two kinds of components can be met by means of the simple structure, thus reducing the difficulty of the process.

Referring to FIG. 4, FIG. 4 is a schematic view showing another structure of the liquid-cooled assembly in the energy storage converter according to an embodiment of the present disclosure. In some embodiments, the coolant inlet 101 is connected to the N flow-splitting channels 111. The coolant inlet 101 is also connected to the component cooling channel 112. The N flow-splitting channels 111 are connected in parallel to each other, and then merge into a main branch, which is then connected in parallel to the component cooling channel 112. That is, an inlet of the component cooling channel 112 is in fluid communication with the coolant inlet 101, and an outlet of the component cooling channel 112 is in fluid communication with the coolant outlet 102. Inlets of the N flow-splitting channels 111 are in fluid communication with the coolant inlet 101, and outlets of the N flow-splitting channels 111 are in fluid communication with the coolant outlet 102. In this way, the coolant can sufficiently cool down the devices through the component cooling channel 112 and the flow-splitting channels 111.

In order to reduce the pressure at the end of each of the pipes in parallel, it is possible to provide a pressure-dividing channel at the end or to increase the diameter of the end, thus ensuring the safety and stability of the liquid-cooled plate.

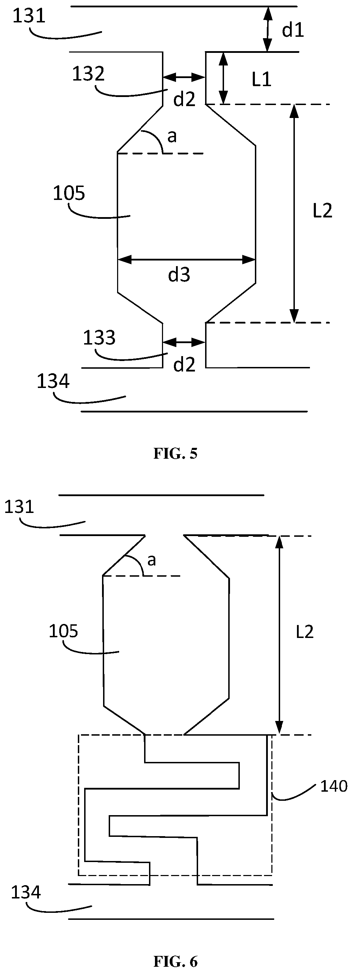

Referring to FIG. 5, FIG. 5 is a schematic view showing a structure of a first sub-flow channel of the liquid-cooled assembly in the energy storage converter according to an embodiment of the present disclosure. In some embodiments, at least one of the first sub-flow channel 121 or the second sub-flow channel 122 includes a first trunk section 131, a first connecting section 132, a cooling region 105, a second connecting section 133, and a second trunk section 134 sequentially connected to each other. The connecting section 132 is provided to buffer the pressure drop from the first trunk section 131 to the cooling region 105, so as to ensure that the velocity at a first water inlet corresponding to the cooling region 105 is relatively uniform, thereby achieving better cooling and heat dissipation effect in the cooling region 105. Similarly, the second connecting section 133 is provided so that the second connecting section 133 can comb the coolant passing through the cooling region 105 and even out the speed of the coolant, which ensures that the coolant in the subsequent second trunk section 134 has a better uniformity, and thus reduces the impact on the liquid-cooled plate, so that the safety of the liquid-cooled plate can be improved, and the service life of the liquid-cooled plate can be improved.

In addition, the first connecting section 132 and the second connecting section 133 are provided so that a distance between two IGBT modules can be increased, and thus, the two IGBT modules can not only dissipate heat through the liquid-cooled plate, but also dissipate heat through their sides, thereby improving the heat dissipation effect on the IGBT modules.

In some embodiments, the first connecting section 132 and the second connecting section 133 are provided to allow bending processing of the liquid-cooled plate corresponding to the cooling region 105, and the surface of the entire liquid-cooled plate still has a large flatness, thereby ensuring the stability of the components located on the liquid-cooled plate and the space utilization of the converter.

In some embodiments, a cross-sectional area of the first connecting section 132 is greater than or equal to a cross-sectional area of the first trunk section 131. In this way, when the cross-sectional area of the first connecting section 132 is equal to the cross-sectional area of the first trunk section, it is ensured that the pressure in another sub-flow channel is similar to the pressure in the first sub-flow channel 121 or the second sub-flow channel 122, and corresponding components have similar heat dissipation effect, thereby ensuring the stability of the IGBT modules. When the cross-sectional area of the first connecting section 132 is greater than the cross-sectional area of the first trunk section 131, it is conductive to making the volume used to prompt the coolant to flow in the first trunk segment smaller than the volume used to prompt the coolant to flow in the cooling region. After the coolant flows into the cooling region, the flow rate of the coolant can be slowed down with the help of the larger volume in the cooling region, and the time for which the coolant remains in the cooling region is increased to further improve the cooling performance of the coolant.

In some embodiments, the cross-sectional area of the first connecting section may be provided to be smaller than the cross-sectional area of the first trunk section, and the cross-sectional area of the first connecting section is also smaller than a cross-sectional area of the cooling region. By shrinking the coolant with the first connecting section, the speed of the coolant is increased, which prompts the coolant to quickly pass through the first connecting section from the first trunk section to enter the cooling region, and thus rapidly cool down the IGBT module to which the cooling region is directly opposite.

The cross-sectional area refers to an area of a pattern taken along a plane perpendicular to the flow direction of the coolant.

In some embodiments, referring to FIG. 5, a ratio between a first width d1 of the first trunk section 131 to a second width d2 of the first connecting section 132 is 0.15 to 1. If the ratio between the first width d1 to the second width d2 is less than 0.15, there is a relatively large difference in cross-sectional area between the first trunk section and the first connecting section, i.e., a relatively large difference in volume between the two. In this case, the coolant from the first trunk section may not be able to completely fill the first connecting section in a relatively short speed, and the coolant has a relatively small speed in the first connecting section, thus being unfavourable to the cooling effect of the coolant. When the ratio of the first width d1 of the first trunk section 131 to the second width d2 of the first connecting section 132 is 0.15 to 1, it is favourable to allow a suitably sized difference between the flow rate of the coolant in the first trunk section and the flow rate of the coolant in the first connecting section to equalize the cooling effects of the coolant in the first trunk section and the first connecting section, which facilitates ensuring that different regions of the liquid-cooled flow channel are all filled with coolant to increase the utilization rate of the liquid-cooled flow channel and enhance the cooling performance of the liquid-cooled plate.

A ratio of the first width d1 to the second width d2 may be 0.16, 0.2, 0.34, 0.41, 0.49, 0.55, 0.64, 0.72, 0.84, or 0.98.

In some embodiments, the first width d1 ranges from 12.5 mm to 30 mm. The first width may be 12.6 mm, 16 mm, 21 mm, 23 mm, 24 mm, 25 mm, 26 mm, 27 mm, 28 mm, or 29 mm. The first trunk section with a width in the above range has a sufficient volume for accommodating the coolant to enhance the cooling effect of the coolant. The above width of the first trunk section can ensure a flow rate of the coolant which enables dissipation of heat from the components of the energy storage converter, and can also ensure fully utilization of the coolant and high security of the liquid-cooled plate.

In some embodiments, the second width d2 ranges from 12.5 mm to 81 mm. The second width d2 may be 12.6 mm, 18 mm, 21 mm, 29 mm, 34 mm, 38 mm, 43 mm, 50 mm, 56 mm, 63 mm, 70 mm, 76 mm, or 80 mm. Within the above range, the width of the first connecting section can reduce the flow rate of the coolant, the low flow rate enabling dissipation of heat from the components of the energy storage converter, and can also ensure fully utilization of the coolant and high security of the liquid-cooled plate.

In some embodiments, a length L1 of the first connecting section 132 ranges from 0 mm to 69 mm. The length of the first connecting section may be 1 mm, 12 mm, 23 mm, 33 mm, 42 mm, 50 mm, 59 mm, or 68 mm.

The length L1 of the first connecting section 132 and a length of the second connecting section 133 in the embodiments of the present disclosure are only for illustrative description, which may be reasonably set by a person skilled in the art according to the location and demand of the IGBT module.

With continued reference to FIG. 5, in some embodiments, a buffer structure is provided in the cooling region 105. The buffer structure enables the coolant that passes through the first connecting section 132 and the first trunk section 131 to slowly fill the cooling region 105, and then sufficiently cool the various regions within the cooling region 105.

In some embodiments, an included angle a between the buffer structure and the first direction is less than 90°. In this way, the buffer structure forms a chamfer-like structure to regulate and balance two regions with different pipe diameters, which ensures a constant pressure and allows the coolant to fill all corners of the cooling region 105. The first direction refers to a direction perpendicular to the flow direction of the coolant.

With continued reference to FIG. 5, the cooling region 105 has a first length L2. The first length L2 is greater than or equal to a length of an IGBT module to ensure that areas contacted by the IGBT module are all in the cooling region 105, so as to improve the heat dissipation area of the IGBT module, thereby make the heat dissipation effect on the IGBT module better.

The length L2 of the cooling region 105 ranges from 56 mm to 152 mm. The length of the cooling region 105 may be 58 mm, 69 mm, 78 mm, 86 mm, 93 mm, 100 mm, 109 mm, 121 mm, 136 mm, or 150 mm.

A third width d3 of the cooling region 105 ranges from 81 mm to 92 mm. The third width d3 may be 82 mm, 83 mm, 84 mm, 85 mm, 86 mm, 87 mm, 88 mm, 89 mm, 90 mm or 91 mm.

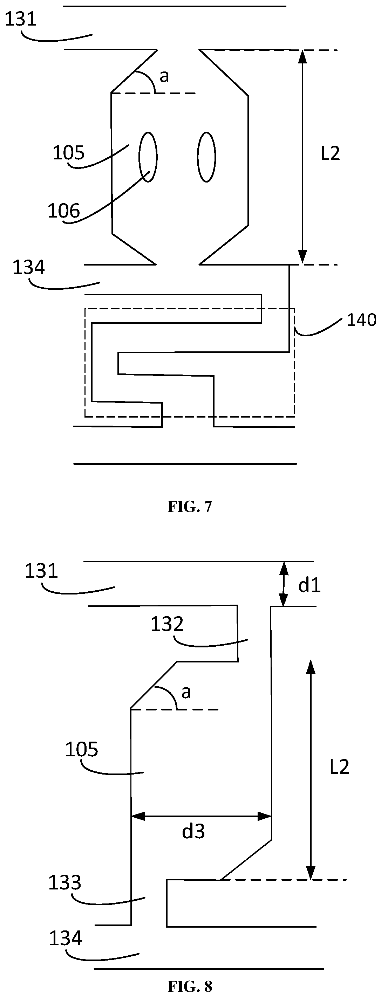

FIG. 6 is a schematic view showing another structure of the first sub-flow channel of the liquid-cooled assembly in the energy storage converter according to an embodiment of the present disclosure. FIG. 7 is a schematic view showing yet another structure of the first sub-flow channel of the liquid-cooled assembly in the energy storage converter according to an embodiment of the present disclosure.

In some embodiments, referring to FIG. 6, at least one of the first sub-flow channel 121 or the second sub-flow channel 122 includes a first trunk section 131, a cooling region 105, a bending section 140, and a second trunk section 134 sequentially connected to each other. The bending section 140 has a number of times of bending greater than or equal to 2.

In some embodiments, referring to FIG. 7, at least one of the first sub-flow channel 121 or the second sub-flow channel 122 includes a connected first trunk section 131, a cooling region 105, a second trunk section 134, and a bending section 140 sequentially connected to each other. The bending section 140 has a number of times of bending greater than or equal to 2.

The first sub-flow channel or the second sub-flow channel shown in FIG. 6 or FIG. 7 is provided with the bending section 140 so that the heat dissipation area of the liquid-cooled assembly is increased and distances between adjacent IGBT modules are balanced.

In some embodiments, the cooling region 105 includes a plurality of first flow channels alternatingly bent. In other words, the liquid flow channel in the cooling region 105 is oriented in series in an S-shape, which is conducive to the discharge of air bubbles, effectively reduces the flow resistance, and at the same time avoids cavitation at the corners.

In some embodiments, referring to FIG. 7, a flow disruption column 106 is provided in the cooling region 105. The flow disruption column 106 can cause the coolant to exchange with each other, thereby filling the corners of the cooling region 105 and sufficiently cooling various regions. The flow disruption column 106 not only enhances the turbulence of the incoming flow, but also conducts the heat from the IGBT module through the column. The coolant creates a wake when passing through the flow disruption column 106, which can enhance the disturbance of the flow and disrupt the development of the wall boundary layer, thereby improving the heat transfer efficiency. In addition, the flow disruption column 106 itself is a heat conductor so that the heat from the IGBT module can be transferred to the flow disruption column 106 and then be taken away through fluid flow.

In some embodiments, the flow disruption column 106 may include a spring-loaded flow disruption ring, a water drop-shaped flow disruption column, a flow disruption ring, or the like.

In some embodiments, the cooling region also has an anti-reverse flow channel section (not shown). The anti-reverse flow channel section includes two fourth sub-flow channels disposed in parallel and a flow-splitting block between the two fourth sub-flow channels, where the flow-splitting block is provided with two guiding ramps (corresponding to the two fourth sub-flow channels) disposed on a sidewall of the flow-splitting block facing the inlet end, and is provided with a resistance groove recessed on a sidewall of the flow-splitting block facing the outlet end. When the fluid flows from the inlet end to the outlet end, the flow resistance is reduced by the guiding ramps, which facilitates the smooth flow of the fluid, whereas when the fluid has a tendency to flow backwards, in the process of flowing from the outlet end to the inlet end, the fluid would firstly impact into the resistance groove, and then perturbs, along the resistance groove, the fluid that flows backwards in the fourth sub-flow channel, which makes the resistance to the fluid that flows backwards increase to prevent generation of a backward flow of the fluid.

In some embodiments, referring to FIG. 5, the cooling region 105 has a first water inlet and a first coolant outlet, and the first water inlet and the first coolant outlet are provided opposite to each other along a second direction. In this way, fixing the IGBT module on the baseplate or liquid-cooled plate can be easier, and the need to set the mounting positions on two sides separately due to the staggering of the first inlet and the first outlet is eliminated, so as to reduce the process difficulty.

FIG. 8 is a schematic view showing still yet another structure of the first sub-flow channel of the liquid-cooled assembly in the energy storage converter according to an embodiment of the present disclosure.

Referring to FIG. 8, the first water inlet and the first coolant outlet are staggered along a second direction. The second direction is a flow direction of the coolant. In this way, the cooling region 105 at the first water inlet and the first coolant outlet can be fully filled, and the staggering of the first water inlet and the first coolant outlet can also improve the disturbance to the coolant.

For illustrative purposes, the flow channel shown in FIGS. 5 to 8 is the first sub-flow channel. In practice, the flow channel shown in FIGS. 5 to 8 may also be the second sub-flow channel or a third sub-flow channel of the component flow channel.

In some embodiments, at least one of the first sub-flow channel 121 or the second sub-flow channel 122 includes a plurality of end flow-splitting channels in parallel. By providing the multi-stage flow-splitting structure, it can be ensured that the flow distribution in various cooling flow channels in the cooling plate is more uniform, so as to ensure a smaller temperature difference on the cooling plate, achieving the cooling and temperature uniformity control of the battery module in the flow channel. For the cooling plate with plate bodies connected in parallel and subjected to multi-stage splitting, on the one hand, the number of splitting stages in the plate body can be reduced effectively, and on the other hand, this structure makes the flow distribution in several flow channels on parallel mother pipes more uniform.

In some embodiments, the component cooling channel 112 includes a plurality of third sub-flow channels connected in parallel, and each third sub-flow channel may adopt the design of the flow channel shown in any one of FIG. 5 to FIG. 8, the third sub-flow channel having a component cooling region 104.

In some embodiments, heat dissipation holes and/or mounting via holes may be provided in locations of the liquid-cooled plate that avoid the cooling channel. It is easy to open holes in the liquid-cooled plate due to its thin thickness. The heat dissipation holes are provided so that the heat dissipation effect of the liquid-cooled assembly can be further improved, and the heat dissipation holes may be straight-through holes or louvered holes. Some electronic devices have raised structures or mounting structures, and the liquid-cooled assembly cannot fit well with these electronic devices. Therefore, mounting via holes can be provided on the liquid-cooled plate to facilitate the passage of the raised structures and the mounting structures alone, and then the rest of the liquid-cooled plate can fit with the electronic devices to dissipate heat.

In some embodiments, a corner in a rounded shape is provided at the connection between flow channel segments. The flow resistance is reduced by the rounded design.

In some embodiments, six IGBT modules may be included. Every two of the six IGBT modules form one group of IGBT modules, IGBT modules in each group of IGBT modules are connected in series to each other, and three groups of IGBT module are connected in parallel to each other. With the arrangement of cooling channels in the liquid-cooled assembly described above, a temperature difference between IGBT modules in each group of IGBT modules can be ensured to be within 5 °C, which in turn realizes temperature balance of the IGBT modules.

In some embodiments, referring to FIG. 2, the component cooling channel 112 of the liquid-cooled assembly corresponds to the inductors 220; the IGBT modules 210 corresponds to the N flow-splitting channels 111 respectively.

In some embodiments, the flow-splitting channel is disposed perpendicular to the IGBT module, so that the contact area between the flow-splitting channel and the IGBT module increases, which can make the heat dissipation effect on the IGBT module better. In some embodiments, the flow-splitting channel and the IGBT module are staggered and inclined to each other.

In some embodiments, a temperature sensor is installed on the liquid-cooled plate 100, which allows real-time monitoring of the temperature of the liquid-cooled plate 100.

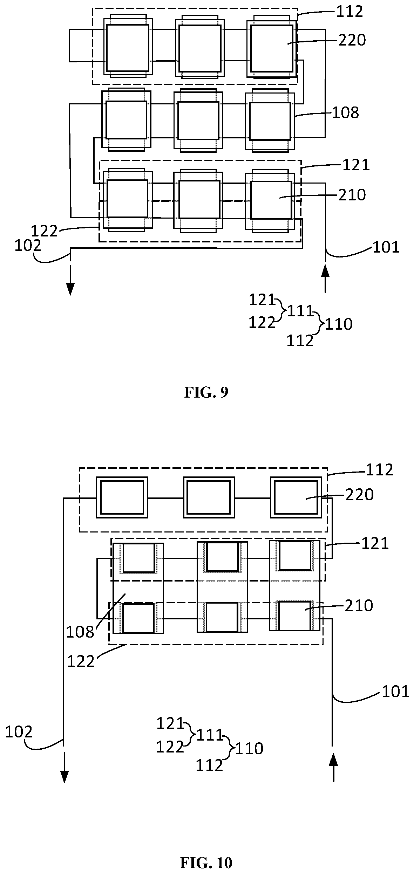

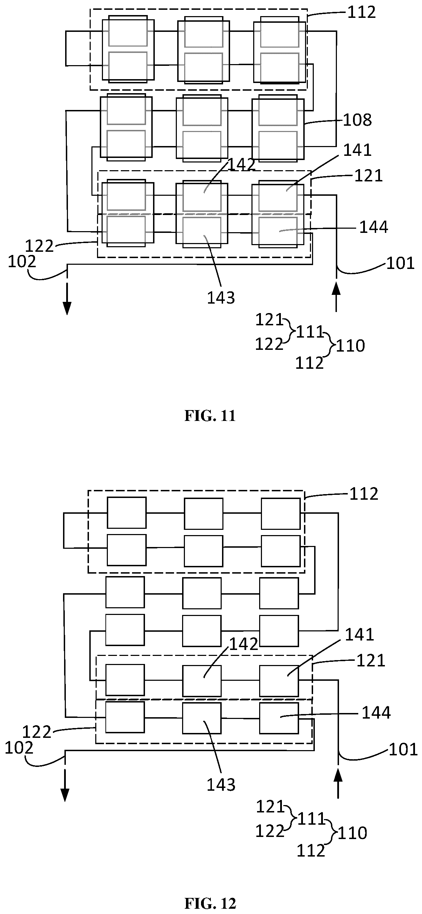

FIG. 9 is another top view of an energy storage converter according to an embodiment of the present disclosure. FIG. 10 is yet another top view of the energy storage converter according to an embodiment of the present disclosure. FIG. 11 is a schematic view showing a structure of a liquid-cooled assembly in the energy storage converter according to an embodiment of the present disclosure. FIG. 12 is a schematic view showing a structure of a flow-splitting structure the liquid-cooled assembly in the energy storage converter according to an embodiment of the present disclosure.

In some embodiments, referring to FIG. 11 or FIG. 12, the liquid-cooled assembly includes: a flow-splitting structure 110. The flow-splitting structure 110 has a coolant inlet 101, N flow-splitting channels 111, and a component cooling channel 112. The N flow-splitting channels 111 and the component cooling channel 112 are in fluid communication with the coolant inlet 101. The N flow-splitting channels 111 are connected in series to each other. The component cooling channel 112 is connected in parallel to the N flow-splitting channels 111, or is connected in series to at least one of the N flow-splitting channels 111.

Referring to FIG. 11 or FIG. 12, in some embodiments, each of the N flow-splitting channels 111 includes a first sub-flow channel 121 and a second sub-flow channel 122. The first sub-flow channel 121 includes at least a first cooling region 141 and a second cooling region 142 sequentially disposed along the flow direction of the coolant. The second sub-flow channel 122 includes at least a third cooling region 143 and a fourth cooling region 144 along the flow direction of the coolant. The first cooling region 141 is disposed opposite to the fourth cooling region 144, and the second cooling region 142 is disposed opposite to the third cooling region 143. The liquid-cooled assembly further includes thermoregulation structures 108. A respective thermoregulation structure 108 of the thermoregulation structures 108 is disposed on the first cooling region 141 and the fourth cooling region 144, or on the second cooling region 142 and the third cooling region 143. In this way, the first sub-flow channel 121 and the second sub-flow channel 122 correspond to each other so that the first cooling region 141 corresponds to the fourth cooling region 144 of the second sub-flow channel 122, and the second cooling region 142 corresponds to the third cooling region 143 of the second sub-flow channel 122. Further, one respective thermoregulation structure 108 is provided on the respective first cooling region 141 and fourth cooling region 144, and another respective thermoregulation structure 108 is provided on the respective second cooling region 142 and third cooling region 143, so that the temperature difference between the cooling regions can be balanced. For example, the temperature difference between the first cooling region 141 and the fourth cooling region 144 is made smaller, the temperature difference between the third cooling region 143 and the second cooling region 142 is made smaller, and temperatures of the first cooling region 141, the fourth cooling region 144, the third cooling region 143 and the second cooling region 142 are balanced according to the flow direction of the coolant, so as to allow the temperatures or heat dissipation effects of the four cooling regions to be similar, which in turn can improve the problem of the uneven flow distribution or temperature difference due to the distance of the flow channels in the liquid-cooled plate, and thus can meet the heat dissipation requirements of the IGBT modules.

In some embodiments, referring to FIG. 9, the N flow-splitting channels 111 include an inlet section and an outlet section, where the inlet section is first sub-flow channels 121, the outlet section is second sub-flow channels 122, and the inlet section is at least partially disposed in close proximity to the outlet section. That is, the first sub-flow channels 121 of the N flow-splitting channels 111 are connected in series to form the inlet section, and the second sub-flow channels 122 of the N flow-splitting channels 111 are connected in series to form the outlet section.

Referring to FIG. 9, in some embodiments, the coolant inlet 101 is connected to first sub-flow channels 121 of the N flow-splitting channels 111, then the first sub-flow channels 121 are connected in series to the component cooling channel 112, and finally, the component cooling channel 112 is connected in series to the second sub-flow channels 122. That is, the first sub-flow channels 121 are used as the inlet section, the second sub-flow channels 122 are used as the outlet section, and the cooling channel first passes through the first sub-flow channels 121, then passes through the component cooling channel 112, and finally passes through the second sub-flow channels 122, which can satisfy the high temperature demand of the IGBT modules, thereby ensuring the heat dissipation effect on the IGBT modules and enabling similar cooling effects on the IGBT modules. For the inductors corresponding to the component cooling channel 112, it is only necessary to ensure the presence of the heat dissipation effect, which can meet the requirements of the component cooling channel 112. Therefore, different requirements of two kinds of components can be met by means of the simple structure, thus reducing the difficulty of the process.

In some embodiments, the inlet section, the component cooling channel 112, and the outlet section are sequentially connected in series to each other. That is, the coolant inlet 101 is connected to the first sub-flow channels 121, then the first sub flow channels 121 are connected in series to the component cooling channel 112, and finally, the component cooling channel 112 is connected in series to the second sub-flow channels 122.

In some embodiments, the inlet section is connected in series to the outlet section, and the inlet section is connected in parallel to the component cooling channel. The coolant inlet is connected to the N flow-splitting channels, and the coolant inlet is connected to the component cooling channel. The N flow-splitting channels are connected in series to each other to form a total channel, and then the total channel is connected in parallel to the component cooling channel. That is, an inlet of the component cooling channel is connected to the coolant inlet, and an outlet of the component cooling channel is connected to the coolant outlet; and inlets of the N flow-splitting channels are connected to the coolant inlet, and outlets of the N flow-splitting channels are connected to the coolant outlet. In this way, the coolant can pass through the component cooling channel and the flow-splitting channels respectively to sufficiently cool down the devices.

In some embodiments, the inlet section has the same shape as the outlet section and is disposed in close proximity to the outlet section. In this way, the coolant has similar flow rates and travelling distances in the inlet section and the outlet section, and has approximately the same thermal energy reduced by cooling in the inlet section and the outlet section, so that a plurality of regions or at least adjacent regions corresponding to the outlet section and the inlet section have approximately the same total thermal energy reduced by cooling. By balancing the temperature difference between the inlet section and the outlet section, the problem of the uneven flow distribution or temperature difference due to the distance of the flow channels in the liquid-cooled plate can be improved, and thus the heat dissipation requirements of the IGBT modules can be met.

In some embodiments, a cross-sectional area of the inlet section is smaller than a cross-sectional area of the outlet section, which is conducive to making the volume used to prompt the coolant to flow in the inlet section smaller than the volume used to prompt the coolant to flow in the outlet section, so that after the coolant flows into the cooling region, the flow rate of the coolant can be slowly reduced with the help of the larger volume in the outlet section, and the time for which the coolant remains in the cooling region is increased to further improve the cooling performance of the coolant.

The cross-sectional area refers to an area of a pattern taken along a plane perpendicular to the flow direction of the coolant.

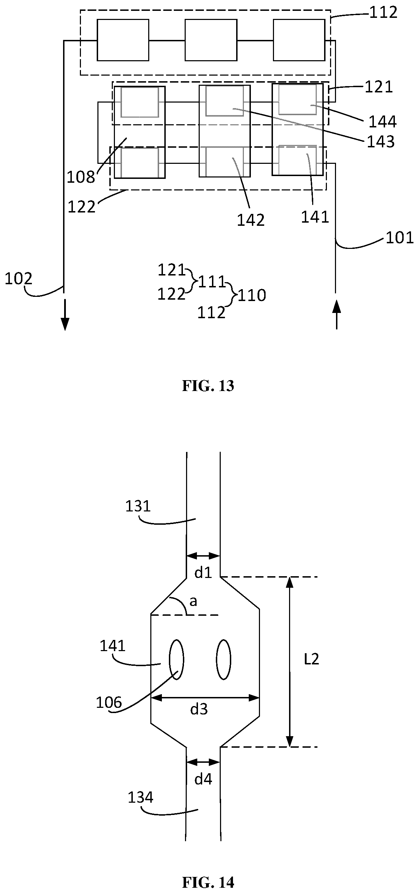

Referring to FIG. 13, FIG. 13 is a schematic view showing another structure of the liquid-cooled assembly in the energy storage converter according to an embodiment of the present disclosure. In some embodiments, along the flow direction of the coolant, the first sub-flow channels 121, the second sub-flow channels 122, and the component cooling channel 112 are connected in series.

In some embodiments, with reference to FIG. 14 which is a schematic view showing a structure of a first sub-flow channel in the liquid-cooled assembly in the energy storage converter according to an embodiment of the present disclosure, at least one of the first sub-flow channel 121 or the second sub-flow channel 122 includes a first trunk section 131, a cooling region, and a second trunk section 134 sequentially connected. The cooling region may be any one of the first cooling region 141, the second cooling region 142, the third cooling region 143 and the fourth cooling region 144.

Lengths of the first trunk section 131 and the second trunk section 134 are designed so that a distance between two IGBT modules can be increased, and thus, the two IGBT modules can not only dissipate heat through the liquid-cooled plate, but also dissipate heat through their sides, thereby improving the heat dissipation effect on the IGBT modules.

In some embodiments, bending processing of the liquid-cooled plate corresponding to the cooling region is performed, and the surface of the entire liquid-cooled plate still has a large flatness, thereby ensuring the stability of the components located on the liquid-cooled plate and the space utilization of the converter.

The lengths of the first trunk section 131 and the second trunk section 134 are not limited by the embodiments of the present disclosure, and may be reasonably set by a person skilled in the art in accordance with the locations and needs of the IGBT modules.

In some embodiments, the cross-sectional area of the first trunk section 131 is equal to the cross-sectional area of the second trunk section 134. In this way, since the smaller the cross-sectional area is, the larger the flow rate of the coolant is, when the coolant has similar pressures in the first trunk section 131 and the second trunk section 134, the heat dissipation effects on corresponding components are similar, so as to ensure the stability of the IGBT modules, and thus avoid the inconsistence in cooling effects on positions where the sub-flow channels are located. A pipe diameter d4 of the second trunk section 134 is equal to a pipe diameter d1 of the first trunk section 131.

In some embodiments, the pipe diameter d1 ranges from 12.5 mm to 30 mm. The pipe diameter d1 may be 12.6 mm, 16 mm, 21 mm, 23 mm, 24 mm, 25 mm, 26 mm, 27 mm, 28 mm, or 29 mm. The pipe diameter of the first trunk section is within any of the above mentioned ranges, and the first trunk section has a sufficient volume for holding the coolant to enhance the cooling effect of the coolant. The width of the first trunk section ensures that the flow rate of the coolant can dissipate heat from the components of the energy storage converter, and also ensures that the coolant can be fully utilized and that the liquid-cooled plate has a high level of safety.

The first trunk section with a pipe diameter (i.e., a width) in the above range has a sufficient volume for accommodating the coolant to enhance the cooling effect of the coolant. The above width of the first trunk section can ensure a flow rate of the coolant which enables dissipation of heat from the components of the energy storage converter, and can also ensure fully utilization of the coolant and high security of the liquid-cooled plate.

FIG. 13 and FIG. 12 only illustrate a first cooling region, a second cooling region, a third cooling region and a fourth cooling region. The first sub-flow channel may further include a fifth cooling region provided adjacent to the second cooling region, and the second sub-flow channel may further include a sixth cooling region provided adjacent to the third cooling region. The fifth cooling region is disposed opposite to the sixth cooling region. By analogy, the first sub-flow channel may include n cooling regions, the second sub-flow channel may include m cooling regions, and one respective cooling region of the n cooling regions is disposed opposite to one respective cooling region of the m cooling regions.

With continued reference to FIG. 13, in some embodiments, a buffer structure is provided in at least one of the first cooling region 141, the second cooling region 142, the third cooling region 143 or the fourth cooling region 144, and the buffer structure may allow the coolant passing through the first trunk section 131 to slowly fill the cooling region, and then sufficiently cool the various regions within the cooling region.

In some embodiments, an included angle a between the buffer structure and the first direction is less than 90°. In this way, the buffer structure forms a chamfer-like structure to regulate and balance two regions with different pipe diameters, which ensures a constant pressure and allows the coolant to fill all corners of the cooling region.

With continued reference to FIG. 14, the cooling region has a first length L2, and the first length L2 is greater than or equal to the length of the IGBT module to ensure that the area contacted by the IGBT module is in the cooling region, thereby increasing the heat dissipation area of the IGBT module to provide better heat dissipation effect on the IGBT module.

The length of the cooling region L2 ranges from 56 mm to 152 mm, and the length of the cooling region may be 58 mm, 69 mm, 78 mm, 86 mm, 93 mm, 100 mm, 109 mm, 121 mm, 136 mm or 150 mm.

The pipe diameter d3 of the cooling region ranges from 81 mm to 92 mm. The pipe diameter d3 may be 82 mm, 83 mm, 84 mm, 85 mm, 86 mm, 87 mm, 88 mm, 89 mm, 90 mm, or 91 mm.

In some embodiments, the pipe diameter d3 of the cooling region is greater than the pipe diameter d1 of the first trunk section 131.

In some embodiments, the ratio of the pipe diameter of the cooling region to the pipe diameter of the first trunk section 131 is 1.5 to 6. If the ratio of the pipe diameter of the cooling region to the pipe diameter d1 of the first trunk section 131 is greater than 6, the first trunk section and the cooling region have a relatively large difference in cross-sectional area, i.e., a relatively large difference in volume between the two. In this case, the coolant from the first trunk section may not be able to completely fill the first connecting section in a relatively short speed, and the coolant has a relatively small speed in the first connecting section, thus being unfavourable to the cooling effect of the coolant. If the ratio of the pipe diameter of the cooling region to the pipe diameter d1 of the first trunk section 131 is less than 1.5, the ratio of the cooling region to the first trunk section is relatively small, in which case, the first trunk section is probably set excessively large, thereby resulting in a waste of the trunk section, or the cooling region is probably set excessively small, resulting in a poorer heat dissipation effect on the IGBT module. When the ratio of the pipe diameter of the cooling region to the pipe diameter of the first trunk section 131 is 1.5 to 6, it is favourable to allow a suitably sized difference between the flow rate of the coolant in the first trunk section and the flow rate of the coolant in the first connecting section to equalize the cooling effects of the coolant in the first trunk section and the first connecting section, which facilitates ensuring that different regions of the liquid-cooled flow channel are all filled with coolant to increase the utilization rate of the liquid-cooled flow channel and enhance the cooling performance of the liquid-cooled plate.

A ratio of the pipe diameter of the cooling region to the pipe diameter d1 of the first trunk section 131 may be 1.6, 1.9, 2.3, 2.8, 3.1, 3.9, 4.5, 5.4, 5.7, or 5.9.

In some embodiments, at least one of the first cooling region 141, the second cooling region 142, the third cooling region 143, or the fourth cooling region 144 includes a plurality of first flow channels alternatingly bent (not shown). In other words, the liquid flow channel within at least one of the first cooling region 141, the second cooling region 142, the third cooling region 143, or the fourth cooling region 144 is oriented in series in an S-shape, which is conducive to the discharge of air bubbles, effectively reduces the flow resistance, and at the same time avoids cavitation at the corners.

In some embodiments, referring to FIG. 14, a flow disruption column 106 is provided in at least one of the first cooling region 141, the second cooling region 142, the third cooling region 143, or the fourth cooling region 144. The flow disruption column 106 can cause the coolant to exchange with each other, thereby filling the corners of the cooling region and sufficiently cooling various regions of the cooling region. The flow disruption column 106 not only enhances the turbulence of the incoming flow, but also conducts the heat from the IGBT module through the column. The coolant creates a wake when passing through the flow disruption column 106, which can enhance the disturbance of the flow and disrupt the development of the wall boundary layer, thereby improving the heat transfer efficiency. In addition, the flow disruption column 106 itself is a heat conductor so that the heat from the IGBT module can be transferred to the flow disruption column 106 and then be taken away through fluid flow.

In some embodiments, the flow disruption column 106 may include may include a spring-loaded flow disruption ring, a water drop-shaped flow disruption column, a flow disruption ring, or the like.

In some embodiments, the cooling region also has an anti-reverse flow channel section. The anti-reverse flow channel section includes two fourth sub-flow channels disposed in parallel and a flow-splitting block between the two fourth sub-flow channels, where the flow-splitting block is provided with two guiding ramps (corresponding to the two fourth sub-flow channels) disposed on a sidewall of the flow-splitting block facing the inlet end, and is provided with a resistance groove recessed on a sidewall of the flow-splitting block facing the outlet end. When the fluid flows from the inlet end to the outlet end, the flow resistance is reduced by the guiding ramps, which facilitates the smooth flow of the fluid, whereas when the fluid has a tendency to flow backwards, in the process of flowing from the outlet end to the inlet end, the fluid would firstly impact into the resistance groove, and then perturbs, along the resistance groove, fluid that flows backwards in the fourth sub-flow channel, which makes the resistance to the fluid that flows backwards increase to prevent generation of a backward flow of the fluid.

In some embodiments, at least one of the first cooling region 141, the second cooling region 142, the third cooling region 143, or the fourth cooling region 144 has a first inlet and a first outlet, and the first inlet and the first outlet are disposed opposite to each other along a second direction. In this way, fixing the IGBT module on the baseplate or liquid-cooled plate can be easier, and the need to set the mounting positions on two sides separately due to the staggering of the first inlet and the first outlet is eliminated, so as to reduce the process difficulty.

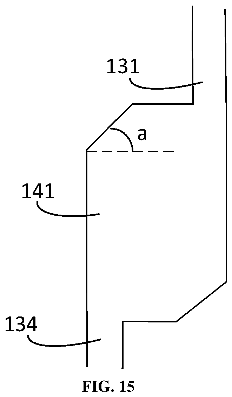

FIG. 15 is a schematic view showing another structure of a first sub-flow channel in the liquid-cooled assembly in the energy storage converter according to an embodiment of the present disclosure. Referring to FIG. 15, the first water inlet and the first coolant outlet are staggered along the second direction. The second direction is a flow direction of the coolant. In this way, the cooling region at the first water inlet and the first coolant outlet can be fully filled, and the staggering of the first water inlet and the first coolant outlet can also improve the disturbance to the coolant.

In some embodiments, at least one of the first sub-flow channel 121 or the second sub-flow channel 122 includes a plurality of end flow-splitting channels in parallel. By providing the multi-stage flow-splitting structure, it can be ensured that the flow distribution in various cooling flow channels in the cooling plate is more uniform, so as to ensure a smaller temperature difference on the cooling plate, achieving the cooling and temperature uniformity control of the battery module in the flow channel. For the cooling plate with plate bodies connected in parallel and subjected to multi-stage splitting, on the one hand, the number of splitting stages in the plate body can be reduced effectively, and on the other hand, this structure makes the flow distribution in several flow channels on parallel mother pipes more uniform.

In some embodiments, the component cooling channel 112 includes a plurality of third sub-flow channels connected in parallel, and each third sub-flow channel may adopt the design of the flow channel shown in any one of FIG. 11 to FIG. 15, the third sub-flow channel having a component cooling region.

In some embodiments, heat dissipation holes and/or mounting via holes may be provided in locations of the liquid-cooled plate that avoid the cooling channel. It is easy to open holes in the liquid-cooled plate due to its thin thickness. The heat dissipation holes are provided so that the heat dissipation effect of the liquid-cooled assembly can be further improved, and the heat dissipation holes may be straight-through holes or louvered holes. Some electronic devices have raised structures or mounting structures, and the liquid-cooled assembly cannot fit well with these electronic devices. Therefore, mounting via holes can be provided on the liquid-cooled plate to facilitate the passage of the raised structures and the mounting structures alone, and then the rest of the liquid-cooled plate can fit with the electronic devices to dissipate heat.

In some embodiments, a corner in a rounded shape is provided at the connection between flow channel segments. The flow resistance is reduced by the rounded design.

Referring to FIG. 9, the component cooling channel of the liquid-cooled assembly corresponds to the inductors 220, and the IGBT modules 210 correspond to the thermoregulation structures 108.

In some embodiments, six IGBT modules may be included. Every two of the six IGBT modules form one group of IGBT modules, IGBT modules in each group of IGBT modules are connected in series to each other, and three groups of IGBT module are connected in parallel to each other. With the arrangement of cooling channels in the liquid-cooled assembly described above, a temperature difference between IGBT modules in each group of IGBT modules can be ensured to be within 5 °C, which in turn realizes temperature balance of the IGBT modules.

Referring to FIG. 9, one IGBT module 210 corresponds to one thermoregulation structure 108, and two cooling regions correspond to one IGBT module. For example, the first cooling region 141 and the fourth cooling region 144 correspond to one IGBT module 210. Referring to FIG. 10, two IGBT modules correspond to one thermoregulation structure 108. One cooling region corresponds to one IGBT module. For example, the first cooling region 141 corresponds to one IGBT module 210.

In some embodiments, the energy storage converter serves as a flexible interface between an energy storage device and a power grid to achieve real-time communication with a battery management system, is developed using highly reliable intelligent power modules, and achieves bidirectional flow of energy between an alternating current (AC) system and a direct current (DC) system through the integrated design of charging and discharging.

In some embodiments, the flow-splitting channel 111 is disposed perpendicular to the IGBT module 210, so that the contact area between the flow-splitting channel 111 and the IGBT module 210 increases, which can make the heat dissipation effect on the IGBT module better. In some embodiments, the flow-splitting channel and the IGBT module are staggered and inclined to each other.

According to some embodiments of the present disclosure, the following examples are provided.

According to some embodiments of the present disclosure, there is provided an energy storage converter. The energy storage converter includes: a shell and a baseplate; inductors and insulated-gate bipolar transistor (IGBT) modules; and a liquid-cooled assembly. The shell and the baseplate form a chamber. The inductors and the IGBT modules are disposed within the chamber. The liquid-cooled assembly is located on the baseplate, and includes a liquid-cooled plate internally provided with a flow-splitting structure, and thermoregulation structures. The flow-splitting structure includes a coolant inlet, N flow-splitting channels and a component cooling channel. The N flow-splitting channels and the component cooling channel are in fluid communication with the coolant inlet. The N flow-splitting channels are connected in serial to each other. The component cooling channel is connected in parallel to the N flow-splitting channels, or connected in series to at least one of the N flow-splitting channels. Each of the N flow-splitting channels includes a first sub-flow channel and a second sub-flow channel. The first sub-flow channel includes at least a first cooling region and a second cooling region sequentially disposed along a flow direction of a coolant. The second sub-flow channel includes at least a third cooling region and a fourth cooling region along the flow direction of the coolant. The first cooling region is disposed opposite to the fourth cooling region, and the second cooling region is disposed opposite to the third cooling region. A respective thermoregulation structure of the thermoregulation structures is disposed on the first cooling region and the fourth cooling region, or on the second cooling region and the third cooling region. The IGBT modules correspond to the thermoregulation structures, and the inductors corresponds to the component cooling channel.

In some embodiments, the N flow-splitting channels include an inlet section and an outlet section, where the inlet section is first sub-flow channels, the outlet section is second sub-flow channels, and the inlet section is at least partially disposed in close proximity to the outlet section.

In some embodiments, the inlet section, the component cooling channel and the outlet section are sequentially connected in series to each other.

In some embodiments, the inlet section is connected in series to the outlet section, and the inlet section is connected in parallel to the component cooling channel.

In some embodiments, the inlet section has the same shape as the outlet section and is disposed in close proximity to the outlet section.

In some embodiments, a cross-sectional area of the inlet section is smaller than a cross-sectional area of the outlet section.

In some embodiments, along the flow direction of the coolant, the first sub-flow channels, the second sub-flow channels, and the component cooling channel are connected in series.

In some embodiments, a buffer structure is disposed in at least one of the first cooling region, the second cooling region, the third cooling region, or the fourth cooling region has a buffer structure, and an included angle between the buffer structure and the first direction is less than 90°.

In some embodiments, at least one of the first cooling region, the second cooling region, the third cooling region or the fourth cooling region includes a plurality of first flow channels alternatingly bent

In some embodiments, a flow disruption column is provided in at least one of the first cooling region, the second cooling region, the third cooling region, or the fourth cooling region.

In some embodiments, at least one of the first cooling region, the second cooling region, the third cooling region, or the fourth cooling region has a first inlet and a first outlet, and the first inlet and the first outlet are disposed opposite to each other along a second direction. In this way, fixing the IGBT module on the baseplate or liquid-cooled plate can be easier, and the need to set the mounting positions on two sides separately due to the staggering of the first inlet and the first outlet is eliminated, so as to reduce the process difficulty.

Some embodiments of the present disclosure provide technical solutions that have at least the following advantages.

The energy storage converter provided by embodiments of the present disclosure is provided with N flow-splitting channels connected in series, thereby alleviating the flow resistance of the pipes and ensuring the safety and the service life of the liquid cooling plate. Each of the N flow-splitting channels includes a first sub-flow channel and a second sub-flow channel. The first sub-flow channel includes at least a first cooling region and a second cooling region sequentially disposed along the flow direction of the coolant. The second sub-flow channel includes at least a third cooling region and a fourth cooling region along the flow direction of the coolant. The first cooling region is disposed opposite to the fourth cooling region, and the second cooling region is disposed opposite to the third cooling region. The liquid-cooled assembly further includes thermoregulation structures. The respective thermoregulation structure is disposed on the respective first cooling region and fourth cooling region, or on the respective second cooling region and third cooling region. In this way, so that the temperature difference between the cooling regions can be balanced. For example, the temperature difference between the first cooling region and the fourth cooling region is made smaller, the temperature difference between the third cooling region and the second cooling region is made smaller, and temperatures of the first cooling region, the fourth cooling region, the third cooling region and the second cooling region are balanced according to the flow direction of the coolant, so as to allow the temperatures or heat dissipation effects of the four cooling regions to be similar, which in turn can improve the problem of the uneven flow distribution or the temperature difference due to distance in the flow channels of the liquid-cooled plate, and thus can meet the heat dissipation requirements of the IGBT modules.

Some embodiments of the present disclosure provide an energy storage converter. The liquid-cooled assembly is provided to include N flow-splitting channels connected in parallel, thereby ensuring uniform and efficient heat dissipation of IGBT modules, so that the heat dissipation effect on the converter is effectively improved. Secondly, N flow-splitting channels 111 are provided to be connected in parallel, which ensures similar cooling effects on the IGBT modules, i.e., satisfying the requirement of uniformity in the cooling effects on the IGBT modules, and facilitating ensuring the service life of the power modules. Thirdly, the N flow-splitting channels 111 and the component cooling channel 112 are configured to cool down, with a cooling channel therebetween, two kinks of components in a limited space, so that the spatial tightness of the liquid-cooled plate can be improved, thereby improving the integration degree inside the converter.

Accordingly, according to some embodiments of the present disclosure, another aspect of embodiments of the present disclosure provides an energy storage battery pack. The energy storage battery pack includes the converter provided in any of the above embodiments. Technical features same as or corresponding to those in the above embodiments are not be repeated in detail herein.

In some embodiments, the energy storage battery pack includes a plurality of battery modules.

In some embodiments, the energy storage battery pack may be a pack in an energy storage cabinet, and the plurality of battery modules are regularly arranged to form the energy storage battery pack. The exact number of battery modules may be set as desired and is not specifically limited herein. Exemplarily, there may be one group, two groups, four groups, five groups, six groups, or the like of battery modules.

In some embodiments, the energy storage battery pack further includes a battery management system (BMS), and the BMS may be used to control and detect the operation of each battery module.

Although disclosed as above with preferred embodiments, the present disclosure is not intended to limit the appended claims, and any person skilled in the art may make several possible changes and modifications without departing from the conception of the present disclosure. Therefore, the protection scope of the present disclosure should be subject to the defined by the claims.

A person of ordinary skill in the art may understand that the above-mentioned implementations are specific embodiments for implementing the present disclosure. In practical application, various modifications can be made in forms and details without departing from the scope of the embodiments of the present disclosure. A person skilled in the art can make various modifications and variations without departing from the scope of embodiments of the present disclosure. Therefore, the protection scope of the present disclosure should be subject to the defined by the claims.

## Claims

1. An energy storage converter, comprising:
a shell (201) and a baseplate, the shell (201) and the baseplate forming a chamber (200);
inductors (220) and insulated-gate bipolar transistor (IGBT) modules (210), disposed within the chamber (200); and
a liquid-cooled assembly, located on the baseplate and including:
a liquid-cooled plate (100), internally provided with a flow-splitting structure (110), wherein the flow-splitting structure (110) includes a coolant inlet (101), N flow-splitting channels (111), and a component cooling channel (112), wherein the N flow-splitting channels (111) and the component cooling channel (112) are in fluid communication with the coolant inlet (101);
wherein the N flow-splitting channels (111) are connected in parallel to each other, and each of the N flow-splitting channels (111) includes a first sub-flow channel (121) and a second sub-flow channel (122) connected in series, wherein N≥2;
wherein the component cooling channel (112) is connected in parallel to the N flow-splitting channels (111), or connected in series to at least one of the N flow-splitting channels (111); and
wherein the N flow-splitting channels (111) corresponds to the IGBT modules (210), and the component cooling channel (112) corresponds to the inductors (220).

2. The energy storage converter according to claim 1, wherein the flow-splitting structure (110) further includes a coolant outlet (101), and in response to the component cooling channel (112) being connected in series to at least one of the N flow-splitting channels (111), inlets of the N flow-splitting channels (111) are in fluid communication with the coolant inlet (101), an outlet of the at least one of the N flow-splitting channels (111) is in fluid communication with an inlet of the component cooling channel (112), and an outlet of the component cooling channel (112) is in fluid communication with the coolant outlet (101).

3. The energy storage converter according to claim 1, wherein the flow-splitting structure (110) further includes a coolant outlet (101), and in response to the component cooling channel (112) being connected in parallel to the N flow-splitting channels (111), an inlet of the component cooling channel (112) is in fluid communication with the coolant inlet (101), an outlet of the component cooling channel (112) is in fluid communication with the coolant outlet (101), inlets of the N flow-splitting channels (111) are in fluid communication with the coolant inlet (101), and outlets of the N flow-splitting channels (111) are in fluid communication with the coolant outlet (101).

4. The energy storage converter according to any one of claims 1 to 3, wherein at least one of the first sub-flow channel (121) and the second sub-flow channel (122) includes a first trunk section (131), a first connecting section (132), a cooling region (105), a second connecting section (133) and a second trunk section (134) sequentially connected to each other, wherein a cross-sectional area of the first connecting section (132) is greater than or equal to a cross-sectional area of the first trunk section (131) ; optionally, a length of the first connecting section (132) ranges from 0 mm to 69 mm.

5. The energy storage converter according to claim 4, wherein a ratio of a first width of the first trunk section (131) to a second width of the first connecting section (132) is 0.15 to 1; optionally, the first width ranges from 12.5 mm to 30 mm; and optionally, the second width ranges from 12.5 mm to 81 mm.

6. The energy storage converter according to claim 4, wherein a length of the cooling region (105) ranges from 56 mm to 152 mm, and a third width of the cooling region (105) ranges from 81 mm to 92 mm.

7. The energy storage converter according to any one of claims 1 to 3, wherein at least one of the first sub-flow channel (121) and the second sub-flow channel (122) includes a first trunk section (131), a cooling region (105), a second trunk section (134), and a bending section sequentially connected to each other, the bending section having a number of times of bending greater than or equal to 2.

8. The energy storage converter according to any one of claims 1 to 3, wherein at least one of the first sub-flow channel (121) and the second sub-flow channel (122) includes a first trunk section (131), a cooling region (105), a bending section, and a second trunk section (134) sequentially connected to each other, the bending section having a number of times of bending greater than or equal to 2.

9. The energy storage converter according to any one of claims 4, 7 and 8, wherein the cooling region (105) has a buffer structure, and an included angle between the buffer structure and a first direction is less than 90°, wherein the first direction is perpendicular to a flow direction of a coolant in the cooling region (105).

10. The energy storage converter according to any one of claims 4 and 7 to 9, wherein the cooling region (105) includes a plurality of first flow channels alternatingly bent.

11. The energy storage converter according to any one of claims 4 and 7 to 10, wherein a flow disruption column (106) is provided in the cooling region (105).

12. The energy storage converter according to claim 11, wherein the flow disruption column (106) include a spring-loaded flow disruption ring, a water drop-shaped flow disruption column, a flow disruption ring.

13. The energy storage converter according to any one of claims 4 and 7 to 12, wherein the cooling region (105) has a first inlet and a first outlet disposed opposite to each other along a second direction or staggered along a second direction, the second direction being a flow direction of a coolant.

14. The energy storage converter according to any one of claim 1 to 13, wherein at least one of the first sub-flow channel (121) or the second sub-flow channel (122) includes a plurality of end flow-splitting channels (111) in parallel.

15. The energy storage converter according to any one of claim 1 to 14, wherein the component cooling channel (112) includes a plurality of third sub-flow channels connected in parallel.
